(19) Europäisches Patentamt
European Patent Office
Office européen des brevets

(11) **EP 3 141 914 B1**

(12) **EUROPEAN PATENT SPECIFICATION**

(45) Date of publication and mention
of the grant of the patent:
**14.11.2018 Bulletin 2018/46**

(51) Int Cl.:
***G01R 15/20*** *(2006.01)*        ***G01R 19/175*** *(2006.01)*

(21) Application number: **15460072.0**

(22) Date of filing: **11.09.2015**

(54) **METHOD OF DETERMINATION OF DC COMPONENT VALUE IN CLIPPED/SATURATED SIGNALS CONTAINING BOTH AC AND DC COMPONENTS**

**VERFAHREN ZUR BESTIMMUNG DES GLEICHSTROMKOMPONENTENWERTES IN BEGRENZTEN/GESÄTTIGTEN SIGNALEN MIT SOWOHL AC- ALS AUCH DC-KOMPONENTEN**

**PROCÉDÉ DE DÉTERMINATION DE LA VALEUR D'UNE COMPOSANTE CC DANS DES SIGNAUX ÉCRÊTÉS/SATURÉS CONTENANT À LA FOIS DES COMPOSANTES CA ET CC**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.03.2017 Bulletin 2017/11**

(73) Proprietor: **ABB Schweiz AG**
**5400 Baden (CH)**

(72) Inventor: **ALOSZKO, Pawel**
**31-421 Krakow (PL)**

(74) Representative: **Chochorowska-Winiarska, Krystyna**
**ABB Sp. z o. o.**
**ul. Zeganska 1**
**04-713 Warszawa (PL)**

(56) References cited:
**US-A1- 2008 157 749**

• **NALEPA RADOSLAW ET AL: "DC-bias current measurement in high power AC grids", 2013 15TH EUROPEAN CONFERENCE ON POWER ELECTRONICS AND APPLICATIONS (EPE), IEEE, 2 September 2013 (2013-09-02), pages 1-5, XP032505522, DOI: 10.1109/EPE.2013.6634380 [retrieved on 2013-10-16]**

**Description**

The present invention is defined by the independent claims and, regarding independent claim 1, concerns a method of determination of DC component value in clipped/saturated signals containing both AC and DC components. The method is applicable for signals obtained from current sensor where only the DC component is fully reproduced and where AC component can be out of sensor's measurement range. The determination of DC component value in such signals is usually used in order to enable its further compensation.

The conventional method to determine DC component value in measured signal relies on pointing out a mean value of the signal. Such method requires full reproduction of the signal at the sensor's output. In some cases AC component magnitude is multiple times higher than the DC component magnitude. In such situations the DC value determination based on conventional method will give incorrect readings. Such method is not applicable when saturation/clipping in measured signal occurs. For high levels of AC component the sensor's output signal is clipped at a saturation level if the instantaneous value exceeds the sensor's measurement range. The conventional methods of dealing with saturation/clipping problem is reduction of AC component in the signal measured by sensor or selection of sensor for the full AC component range. These methods are either costly or result in lowering of the sensor accuracy.

From a publication " DC-bias current measurement in high power AC grids" by Radostaw Nalepa, Filip Grecki, Magdalena Ostrogórska, Pawel Aloszko, Janusz Duc, presented on 15th European Conference On Power Electronics and Applications (EPE), IEEE, 2 September 2013, pages 1-5, measurement of small DC-bias current, being a part of large AC current in power grids is known.

The essence of a method of determination of DC component value $V_{DC}$ in signals clipped at a saturation level and containing both AC and DC components in a current-carrying wire, around which there is located a magnetic core provided with a gap, by using a current sensor placed in the gap and by detecting signal zero crossing events one by one and storing the measured data in a computer processing unit, is that the method further comprises the following steps:

- determination of a time error indicator $t_{err}$ by comparing signal zero crossing events' times $t_n$, $t_{n-1}$, $t_{n-2}$, in a time error module of the processing unit, using a following formula:

$$t_{err} = t_n - 2t_{n-1} + t_{n-2}$$

where:
- $t_n$ - is the time of currently detected signal zero crossing,
  $t_{n-1}$ - is the time of previously detected signal zero crossing,
  $t_{n-2}$ - is the time of signal zero crossing detected two iterations before,
- determination of DC component value $V_{DC}$ in an integration module of the processing unit using the formula:

$$V_{DC} = k \int t_{err}\, dt$$

where k is a scaling coefficient of calibration given by the user. $t_{err}$ is the time error indicator,
- modification of the DC component value in continuous way by using an iteration method for the determination of the time error indicator $t_{err}$ and determination of DC component value in the previous two steps,
- transferring the information about the DC component value through an output interface of the processing unit to the user interface for a future analysis and for controlling.

Preferably the scaling coefficient k is calculated from the known time error indicator $t_{err}$ for a calibration purpose according to a formula:

$$k=1/t_{err.}$$

Preferably the current sensor is connected with the processing unit through a digital converter for sampling measured current signal.

The essence of a computer program product for determination of DC component value in signals clipped at a saturation level and containing both AC and DC components in which a magnetic core provided with a gap, located around current-carrying wire is used, which said computer program product is loadable into the executable in the computer processing unit, is that during program run it is configured to executes the method according to claims 1-4.

The advantage of the invented method is ability to accurately measure the DC component of signal if the AC component exceeds the measurement range of the sensor. This feature can be used for improvement of maximum AC component magnitude characterizing the sensor or can enable use of sensor scaled for lower AC component magnitude. The invented method is less expensive in comparison with the conventional method or the sensor has a smaller footprint. The invented method enable to achieve more accurate DC component value measurement without being limited by AC component level.

The subject of the invention is presented as an embodiment in the drawing, where:

fig.1 presents - a block diagram of the system for measurement DC component in clipped/saturated signals containing both AC and DC components,

fig.2 - a diagram of measured current signal waveform S(t), containing AC and DC signals with a sensor saturation level Is, with indication of zero crossing events,

fig.3 - a flowchart of operations performed while determining DC component value where AC component is out of sensor's measurement range.

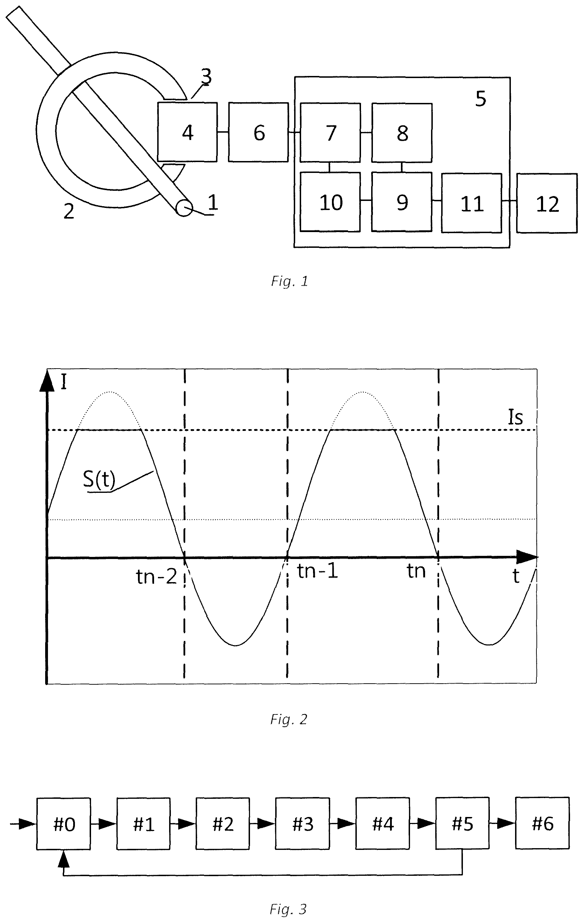

The method according to the invention is explained in the exemplary embodiment using the system presented in fig. 1. The system for measuring the direct component of alternating current comprises a current- currying wire 1 around which there is located a magnetic core 2 provided with a gap 3. In the gap 3 the magnetic field current sensor 4 is inserted. The sensor 4, capable of measuring DC component and AC component is connected with a processing unit 5 through analog to digital converter 6 which is adapted for sampling the measured current signal. Processing unit 5 is a computer processor equipped with a zero crossing detection module 7, a time error calculation module 8, an integrating module 9, connected with a conventional memory module 10 and output interface 11. The others standard elements of the processing unit 5 are not presented in the drawing. The output interface 11 is connected with a user interface 12 for further use in other devices, what is not presented in the drawing.

The method of DC component value determination from signal containing AC component and DC component wherein the AC component of signal exceeds the sensor's measurement range is presented in the following steps:

**STEP # 0** - **current measurement**

In the step # 0 a measurement of current containing AC and DC component by current sensor 4 is provided. The measured signals are converted from analog to digital form by a converter 6 in the known way and a sampled signal waveform S(t) is delivered to the processing unit 5. In the processing unit the sampled signal waveform S(t) is processed as in step #1 - step #6.

**STEP #1 - zero crossing detection**

In the step #1 a zero crossing event detection is realized. Each zero crossing event is detected one by one in the sampled signal S(t) acquired in step #0. The zero crossing detection is done by module 7 of the processing unit 5. The zero crossing is considered detected if the sampled signal sign is changed from positive to negative or vice versa. The zero crossing event is presented in the fig. 2 for the sampled signal waveform, where:

$t_n$ - indicates the time of currently detected zero crossing,

$t_{n-1}$ - indicates the time of previously detected zero crossing (default value = 0, at 1$^{st}$ loop iteration),

$t_{n-2}$ - indicates the time of zero crossing detected two iterations before (default value = 0, at 1$^{st}$ loop iteration).

If zero crossing is not detected in the sampled signal, STEP #0 is repeated.

**STEP #2** - **data storing**

In the step # 2 the data concerning the time $t_n$ of the last detected zero crossing event is stored in the memory module 10.

**STEP #3** - **determination of a time error indicator**

In the step #3 a time error indicator $t_{err}$ is calculated as result of the difference of times between neighbor zero crossings $t_n$, previous zero crossing $t_{n-1}$ and a zero crossing detected two iterations before $t_{n-2}$ , what is performed in the module 8 and 10 according to the formula:

$$t_{err} = t_n - 2t_{n-1} + t_{n-2} \tag{1}$$

where:

$t_n$ - is the time of currently detected zero crossing,

$t_{n-1}$ - is the time of previously detected zero crossing (default value = 0),

$t_{n-2}$ - is the time of zero crossing detected two iterations before (default value = 0).

If the detected zero crossing is the first one, then $t_{n-1}=0$ and $t_{n-2}=0$. If detected zero crossing is the second one, then $t_{n-2}=0$. Otherwise the $t_{n-1}$ is the time of previous zero crossing stored in the memory module 9 and $t_{n-2}$ is the time of zero crossing stored before the time $t_{n-1}$.

**STEP #4** - **DC component value determination**

In the step #4 DC component value $V_{DC}$ is determined basing on the time error indicator $t_{err}$ calculated in the step #3 according to the formula:

$$V_{DC} = k \int t_{err} \, dt$$

k is the scaling coefficient which is used for calibration. Its value should be set experimentally to adjust the output interface 11 readings to user interface 12 range, which is not described. To verify the coefficient k the calibration needs to be done experimentally. This is done by assuming the default value of k=1. Then known value of DC current needs to be applied to the wire 1. The calculated $t_{err}$ value can be read on the user interface 12. The k coefficient should be calculated according to formula:

$$k=1/t_{err} \tag{3}$$

The value of DC component is a result of an integral of the time error indicator $t_{err}$ , which indicator is updated for each zero crossing event, detected in module 7. The higher is the DC component value, the higher values has the time error indicator $t_{err}$, calculated in the module 8.
The result of the step # 4 is transferred to an output interface module 11 and to the memory module 9 for modification.

**STEP #5** - **the DC component value modification**

In this step which is carried out after completion the step #4 in the memory module 9, following data is modified according to formula (4) and (5) and stored in the memory module 9 for updating the time error indicator $t_{err}$ calculation.

$$t_{n-2} = t_{n-1} \tag{4}$$

$$t_{n-1} = t_n \tag{5}$$

$t_n$ - time of currently detected zero crossing,

$t_{n-1}$ - time of previously detected zero crossing (default value = 0, at 1st loop iteration),

$t_{n-2}$ - time of zero crossing detected two iterations before (default value = 0, at 1st loop iteration).

**STEP # 6 Result visualization**

The result is visualized in user interface module 12, according to data received from output interface module 11. The data is available for further use by other devices, which is not presented in the drawing.

**Claims**

1. A method of determination of DC component value $V_{DC}$ in signals clipped at a saturation level and containing both AC and DC components in a current-carrying wire (1) around which there is located a magnetic core (2) provided with a gap (3), by using current measurement carried out by a current sensor (4) placed in the gap (3) and by detecting signal zero crossing events one by one and storing the measured data in a computer processing unit (5), wherein the method further comprises the following steps:

   - determination of a time error indicator $t_{err}$ by comparing signal zero crossing events times $t_n$, $t_{n-1}$, $t_{n-2}$, in a time error module (8) of the processing unit (5) using a formula:

   $$t_{err} = t_n - 2t_{n-1} + t_{n-2}$$

   where:

   $t_n$ - is the time of currently detected signal zero crossing,
   $t_{n-1}$ - is the time of previously detected signal zero crossing,
   $t_{n-2}$ - is the time of signal zero crossing detected two iterations before,

   - determination of DC component value $V_{DC}$ in an integration module (10) of the processing unit using the formula:

   $$V_{DC} = k \int t_{err}\, dt$$

   where k- is a scaling coefficient of calibration given by a user, $t_{err}$ - is the time error indicator,
   - modification of the DC component value in continuous way by using an iteration method for the determination of the time error indicator $t_{err}$ and determination of the DC component value in the previous two steps,
   - and transferring information about the DC component value through an output interface (11) of the processing unit (5) to a user interface (12) for a future analysis and for controlling.

2. The method according to claim 1, **characterized in that** the scaling coefficient k is calculated from the known time error indicator $t_{err}$ for a calibration purpose according to a formula:

   $$k = 1/t_{err} .$$

3. The method according to claim 1, **characterized in that** the current sensor (4) is connected with the processing unit (5) through a digital converter (6).

4. The method according to claim 3, **characterized in that** the digital converter (6) is adapted for sampling measured current signal.

5. A computer program product for determination of DC component value in signals clipped at a saturation level and containing both AC and DC components, in which a magnetic core (2) provided with a gap (3) and located around a current- carrying wire (1) is used, which said computer program product is loadable into the executable in a computer processing unit (5) and wherein during program run it is configured to execute the method according to claims 1-4.

**Patentansprüche**

1. Verfahren zur Bestimmung des Gleichstromkomponentenwertes in begrenzten/gesättigten Signalen mit sowohl AC- als auch DC-Komponenten in einer mit Strom belasteten Kabelleitung (1), welche mit einem magnetischen Kern (2) mit einer Spaltung (3) umhüllt ist, und zwar durch die Bestimmung des Stroms mit einem in der Spaltung (3) befestigten Stromsensor (4) und durch die Erfassung der nacheinander folgenden Ereignissen des Übergangs des Signalwerts durch den Nullpunkt und die Speicherung von Messdaten in einer EDV-Einheit (5), wobei dieses Verfahren folgende weitere Schritte umfasst:

   - Ermittlung des Zeitfehlerkoeffizienten $t_{err}$ durch den Vergleich der Dauer von Ereignissen des Übergangs des Signalwerts durch den Nullpunkt $t_n$, $t_{n-1}$, $t_{n-2}$, in dem Zeitfehlermodul (8) der EDV-Einheit (5) nach folgender Formel:

$$t_{err} = t_n - 2t_{n-1} + t_{n-2}$$

   wobei:

   $t_n$ - die Dauer des aktuell erfassten Übergangs durch den Nullpunkt,
   $t_{n-1}$ - die Dauer des vorher erfassten Übergangs durch den Nullpunkt,
   $t_{n-2}$ - die Dauer des zwei Zyklen zuvor erfassten Übergangs durch den Nullwert ist,

   - Ermittlung des Gleichstromkomponentenwertes $V_{DC}$ in dem Integrationsmodul (10) der EDV-Einheit nach folgender Formel:

$$V_{DC} = k \int t_{err}\, dt$$

   wobei k ein vom Nutzer angegebener Kalibrierungskoeffizient und
   $t_{err}$ - der Zeitfehlerkoeffizient ist,
   - durchgehende Modifizierung des Gleichstromkomponentenwertes durch die Anwendung der Zyklenmethodik für die Ermittlung des Zeitfehlerkoeffizienten $t_{err}$ und die Ermittlung des Gleichstromkomponentenwertes in den zwei oben beschriebenen Schritten,
   - und die Übertragung der Informationen über den Gleichstromkomponentenwert durch ein Ausgabewerk (11) der EDV-Einheit (5) an das Eingabewerk des Nutzers (12) zur weiteren Analyse und Steuerung.

2. Die Methode nach Anspruch 1, **dadurch gekennzeichnet, dass** Zwecks Kalibrierung der Kalibrierungskoeffizient k aus dem bekannten Zeitfehlerkoeffizient $t_{err}$ nach folgender Formel ermittelt wird:

$$k = 1/t_{err} .$$

3. Die Methode nach Anspruch 1, **dadurch gekennzeichnet, dass** der Stromsensor (4) mit der EDV-Einheit (5) durch einen digitalen Wandler (6) verbunden ist.

4. Die Methode nach Anspruch 3, **dadurch gekennzeichnet, dass** der digitale Wandler (6) zur Erfassung der Stichproben von gemessenem Stromsignal angepasst ist.

5. Eine Rechneranwendung für zur Bestimmung des Gleichstromkomponentenwertes in begrenzten/gesättigten Signalen mit sowohl AC- als auch DC-Komponenten, in welcher ein die mit Strom belastete Kabelleitung (1) umhüllender magnetischer Kern (2) mit einer Spaltung (3) angewandt wird, wobei diese Anwendung in der EDV-Einheit (5) gespeichert und während der Ausführung für die Durchführung des Verfahrens nach Ansprüchen 1-4 konfiguriert werden kann.

**Revendications**

1.  Procédé de détermination de la valeur $V_{DC}$ d'une composante CC dans des signaux décrétés / saturés contenant à la fois des composantes CA et CC dans le fil chargé de courant électrique (1) autour duquel se trouve un noyau magnétique (2) muni d'une fente (3), en procédant à la mesure du courant conduit par le capteur de courant électrique (4) placé dans la fente (3) ainsi que par la détection des événements successifs de passage du signal par le zéro et l'enregistrement des données de mesure dans l'unité de traitement (5), étant entendu que ce procédé comporte en outre les pas suivants :

    - la détermination de l'indice d'erreur de temps $t_{err}$ par la comparaison des temps de l'événement de passages du signal par le zéro $t_n$, $t_{n-1}$, $t_{n-2}$, dans le module d'erreur de temps (8) de l'organe de traitement (5) selon la formule :

    $$t_{err} = t_n - 2t_{n-1} + t_{n-2}$$

    où :

       $t_n$ - est le temps actuellement détecté du passage du signal par le zéro,
       $t_{n-1}$ - est le temps précédemment détecté du passage du signal par le zéro,
       tn-2 - est le temps du passage du signal par le zéro, détecté deux itérations avant,

    - la détermination de la valeur $V_{DC}$ de la composante CC dans le module d'intégration (10) de l'organe de traitement selon la formule :

    $$V_{DC} = k \int t_{err} \, dt$$

    où k - est le coefficient de graduation consigné par l'utilisateur lors de la calibration,
    $t_{err}$ - est l'indice d'erreur de temps,
    - la modification de la valeur de la composante CC de la manière continue, par l'utilisation de la méthode d'itération pour la détermination de l'indice d'erreur de temps $t_{err}$ et la détermination de la valeur de CC dans les deux derniers pas,
    - et le transfert de l'information sur la valeur de CC par l'interface de sortie (11) de l'unité de traitement (5) de l'interface de l'utilisateur (12) pour la future analyse et pour les besoins de commande.

2.  Procédé selon la revendication 1, **caractérisé en ce que** le coefficient de graduation k est calculé à partir de l'indice connu d'erreur de temps $t_{err}$ pour la calibration selon la formule : $k=1/t_{err}$.

3.  Procédé selon la revendication 1, **caractérisé en ce que** le capteur de courant électrique (4) est connecté avec l'unité de traitement (5) par le convertisseur numérique (6).

4.  Procédé selon la revendication 3, **caractérisé en ce que** le convertisseur numérique est adapté à prélever des échantillons du signal de courant mesuré.

5.  Le produit comprenant le logiciel informatique de l'ordinateur pour la détermination de la valeur de la composante CC dans des signaux décrétés / saturés contenant à la fois des composantes CA et CC, dans lequel est utilisé le noyau magnétique (2) muni d'une fente (3) et qui est placé autour d'un fil chargé de courant électrique (1), et que ledit logiciel informatique peut être téléchargé au fichier exécutable à l'unité de traitement (5), étant entendu que durant l'exécution le programme est configuré pour exécuter le procédé selon les revendications de 1 à 4.

Fig. 1

Fig. 2

Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- DC-bias current measurement in high power AC grids. **RADOSTAW NALEPA ; FILIP GRECKI ; MAGDALENA OSTROGÓRSKA ; PAWEL ALOSZKO ; JANUSZ DUC.** 15th European Conference On Power Electronics and Applications (EPE). IEEE, 02 September 2013, 1-5